Europäisches Patentamt

European Patent Office

Office européen des brevets

(19)

(11) Publication number : **0 490 640 A1**

# (12) EUROPEAN PATENT APPLICATION

(21) Application number : **91311477.3**

(22) Date of filing : **10.12.91**

(51) Int. Cl.$^5$ : **H01L 27/12, H01L 21/84, G09G 3/36**

(30) Priority : **10.12.90 JP 415722/90**

(43) Date of publication of application :
**17.06.92 Bulletin 92/25**

(84) Designated Contracting States :
**DE FR GB**

(71) Applicant : **SEMICONDUCTOR ENERGY LABORATORY CO., LTD.**
**398 Hase**
**Atsugi-shi Kanagawa-ken, 243 (JP)**

(72) Inventor : **Hiroki, Masaaki**
**533-13, Shirane**
**Isehara-shi, Kanagawa-ken 259-11 (JP)**
Inventor : **Mase, Akira**
**3-3, 381-1, Hase**
**Atsugi-shi, Kanagawa-ken, 243 (JP)**

(74) Representative : **Milhench, Howard Leslie et al**
**R.G.C. Jenkins & Co. 26 Caxton Street**
**London SW1H 0RJ (GB)**

(54) **Electronic devices, particularly for use as electro-optic devices.**

(57) A novel structure of an active electro-optic device is disclosed. The device is provided with a pair of complementary transistors therein which comprise a p-channel TFT and an n-channel TFT. In the case of a liquid crystal electro-optic device, the device comprises a pair of substrates, a liquid crystal provided therebetween, picture element electrode areas arranged in a matrix form and provided on one of the substrates, complementary transistors provided thereon, and signal lines provided thereon. Gate electrodes of p-channel and n-channel transistors of these complementary transistors are connected to some of the signal lines while source (or drain) electrodes thereof are connected to the electrode areas and drain (or source) electrodes thereof are connected to other signal lines.

FIG. 2

EP 0 490 640 A1

## BACKGROUND OF THE INVENTION

### Field of the Invention

The present invention relates generally to electronic devices such as active electro-optic devices, e.g. active liquid crystal electro-optic devices, and more particularly though not exclusively concerns devices provided with thin-film gate insulated field effect transistors (hereinafter referred to as TFTs) associated with their picture elements.

### Description of the Prior Art

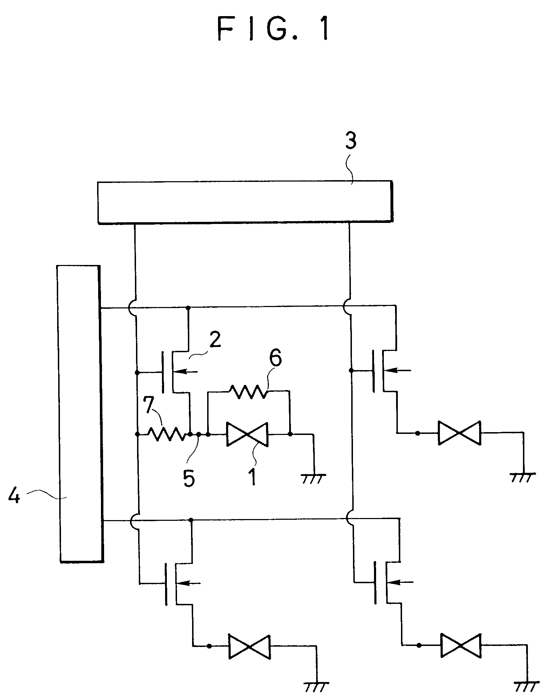

An active type liquid crystal electro-optic device utilizing TFTs is known in the art. In this conventional device, an amorphous or polycrystalline semiconductor is used for the TFT, while either a p-channel or n-channel TFT is provided for each picture element thereof. A typical example thereof is indicated in Fig. 1 of the accompanying drawings.

Referring to Fig. 1, which shows the equivalent circuit of a liquid crystal electro-optic device in a matrix format, it can be seen that an NTFT is linked to a liquid crystal 1 in series therewith.

In general, large matrix display devices such as 640 x 480 pixel or 1260 x 960 pixel matrix display devices are used, but in the drawing only a simple example of a 2 x 2 matrix arrangement is shown for convenience. Voltage is supplied from the peripheral circuits 3, 4 to each picture element. The picture elements are turned ON or OFF in accordance with their applied voltage. When the ON/OFF characteristic of a TFT is good, a liquid crystal electro-optic device of high contrast can generally be prepared. When liquid crystal electro-optic devices are actually manufactured, however, it is often the case that the voltage $V_{LC}$ 5 at the output of the TFT, i.e. the input to the liquid crystal (referred to as the liquid crystal electric potential) does not become a "1" (a high voltage level) when it should be a "1", or otherwise does not become a "0" (a low voltage level) when it should be a "0". This problem occurs when the TFT which is a switching device applying a signal to the picture element, is put into an asymmetrical state in the OF/OFF condition.

The liquid crystal 1 is basically insulating, and the liquid crystal electric potential ($V_{LC}$) floats when the TFT is OFF. Since the liquid crystal 1 is equivalent to a capacitor, the $V_{LC}$ can be determined by the charge accumulated therein. When the resistance of the liquid crystal becomes comparatively small at $R_{LC}$ 6, or current leakage occurs due to the existence of dust or an ionic impurity, or when a pin hole is formed in the gate insulating film of the TFT as shown in Fig. 1 at $R_{GS}$ 7, the charge can leak therefrom whereby $V_{LC}$ may be put into an unstable condition. For this reason, a high yield cannot be achieved in liquid crystal electro-optic devices that have as many as 200,000-5,000,000 pieces of picture element in one panel. TN (Twisted Nematic) liquid crystal is typically used for the liquid crystal material 1, and for the orientation of the liquid crystal, a rubbed orientation control film is provided on each electrode of the display. Due to the static electricity generated in the rubbing process, weak dielectric breakdown occurs and leakage occurs between adjacent conductors such as picture element electrodes and electric lines (wires), or leakage occurs in the weak gate insulating film. For active liquid crystal electro-optic devices, it is of particular importance to maintain a certain level of the liquid crystal electric potential at the same value as an initial value in one frame. Practically, however, this is not always the case because a lot of defects exist in the TFT part.

In the case where the liquid crystal material is a ferroelectric liquid crystal, it is necessary to increase injection current. For that purpose, the TFTs must be increased in size so as to increase the current margin, which again is a disadvantage.

## OBJECTS AND BRIEF SUMMARY OF THE INVENTION

The object of the present invention is to overcome or at least substantially reduce the abovementioned problems. More particularly, it is seen that there is an unfulfilled requirement for an electro-optic device with a stable performance derived from stable driving signal levels of '1' and '0', and the present invention seeks to fulfil this requirement.

In accordance with one aspect of the present invention, an electro-optic device is provided with a picture element electrode island on a substrate thereof, a first signal line thereon, a second signal line thereon, and complementary transistors comprising a p-channel TFT and an n-channel TFT thereon, one of the input/output terminals of the p-channel TFT and one of the input/output terminals of the n-channel TFT being connected to the electrode island while the other one of the input/output terminals of the p-channel TFT and the other one of the input/output terminals of the n-channel TFT are connected to the first line and gate electrodes of the p-channel and n-channel TFTs are connected to the second signal line. A matrix display device can be obtained by reproducing the above structure a number of times on the substrate.

The complementary thin-film transistors in accordance with the present invention preferably are complementary thin-film transistors (hereinafter referred to as C/TFTs) in which one of the input/output terminals of an N-channel thin-film transistor (hereinafter referred to as NTFT) and one of the input/output terminals of a P-channel thin-film transistor (hereinafter referred to as PTFT) are connected with one another, gate electrodes of the P-and N-channel thin-film transistors are connected with one another, and the connected terminals work as a source or drain electrode.

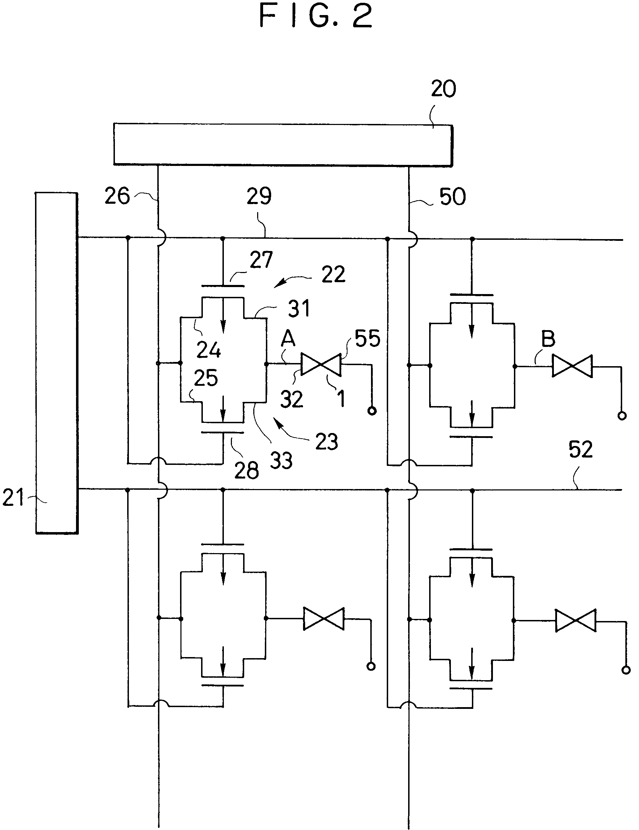

The equivalent circuit of a typical electro-optic device in accordance with the teachings of the present invention is shown in Fig. 2 which shows an exemplary 2 x 2 matrix driven by peripheral circuits 20, 21 one side 24 of the source and drain electrodes of PTFT 22 and one side 25 of the source and drain electrodes of NTFT 23 being connected to one signal line $V_{DD}$ 26, while the others are connected to an electrode 32 of a picture element; and gates 27, 28 being connected to the other signal line $V_{GG}$ 29. By forming such a structure, a liquid crystal electro-optic device is obtained which allows the electric potential applied to the picture element electrode at the time of ON/OFF of the C/TFTs comprising PTFT 11 and NTFT to be stable enough to be fixed to "1" or "0" whereby the level does not drift in one frame period.

By providing complementary gate insulated field effect transistors for each picture element, so as to control the voltage applied to the picture element of the display, a liquid crystal electro-optic device that has a clear ON/OFF characteristic is obtained.

The above and further features of the present invention are set forth with particularity in the appended claims and should become clearer to those possessed of appropriate knowledge and skills from consideration of the following description given with reference to the accompanying drawings.

## BRIEF DESCRIPTION OF THE DRAWINGS

Fig. 1 shows an example of the circuit of a conventional active matrix liquid crystal electro-optic device;

Fig. 2 shows an example of the circuit of an active matrix liquid crystal electro-optic device in accordance with the present invention;

Figs. 3(A) - (F) are schematic cross-sectional views showing an exemplary manufacturing process for TFTs which is applicable to the present invention;

Fig. 4(A) is a plan view showing an example of the arrangement of electrodes and of the TFTs in an active matrix liquid crystal electro-optic device in accordance with the present invention; and Fig. 4(B) and Fig. 4(C) are cross-sectional views at the positions indicated by the lines A-A' and B-B' shown in Fig. 4(A), respectively;

Fig. 5 shows driving signal waveforms input to each signal line at the time of driving an active matrix liquid crystal electro-optic device in accordance with the present invention;

Fig. 6(A) is a plan view showing another example of arrangement of the electrodes and TFTs in an active matrix liquid crystal electro-optic device in accordance with the present invention; and Fig. 6(B) and Fig. 6(C) are cross-sectional views at the positions indicated by the lines C-C' and D-D' of Fig. 6(A), respectively;

Figs. 7(A)-(G) are cross-sectional views showing the manufacturing process of the TFTs in a third exemplary embodiment of the present invention; and

Fig. 8(A) is a plan view showing part of an active matrix liquid crystal electro-optic device in accordance with the third embodiment of the present invention, Fig. 8(B) and Fig. 8(C) being cross-sectional views at the positions indicated by the lines F-F' and E-E' shown in Fig. 8(A), respectively.

## DETAILED DESCRIPTION OF THE EMBODIMENTS

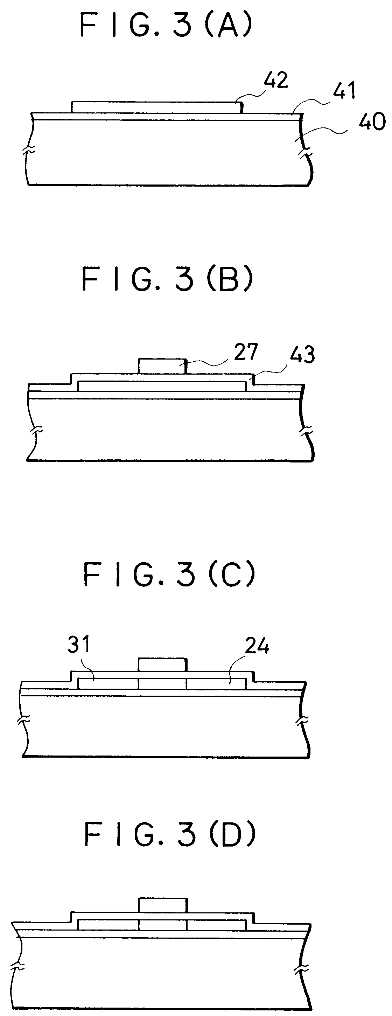

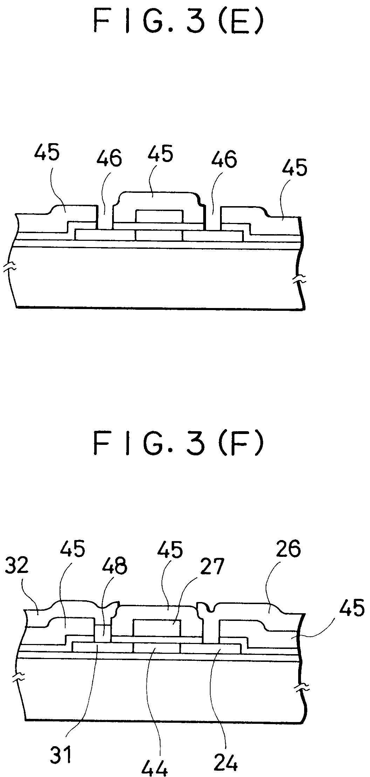

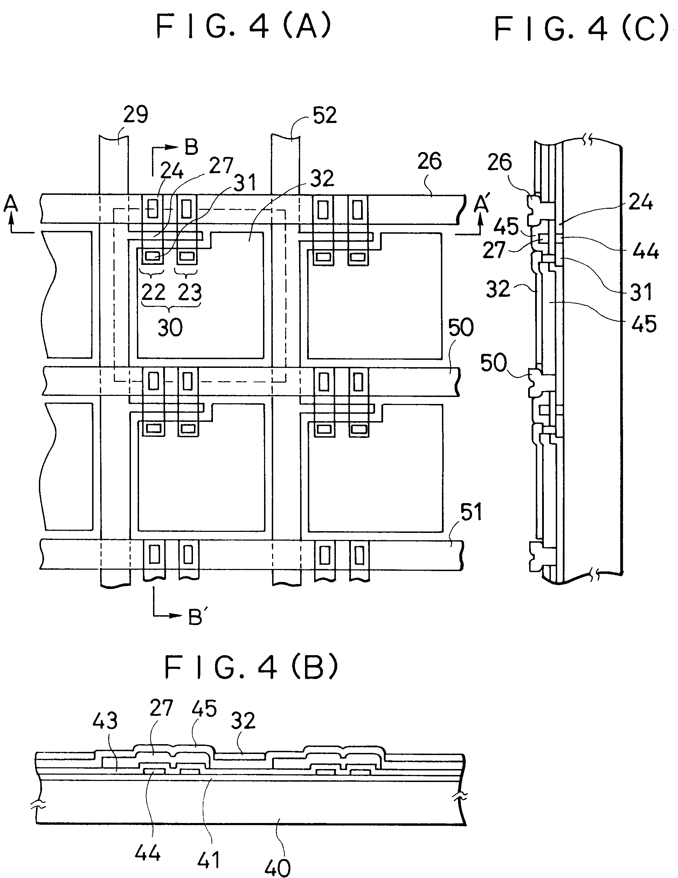

Referring to Figs. 3 and 4, a display device conforming to Fig. 2 and in accordance with a first embodiment of the present invention will now be described. The manufacturing process of the TFTs associated with the picture elements of the device will be explained by reference to Fig. 3, the manufacturing method of the PTFTs 22 being the main subject of the following explanations and the NTFTs 23 being manufactured by basically the same manufacturing process.

Referring to Fig. 3, a blocking layer comprising a silicon oxide film 41 was formed by magnetron RF (high frequency) sputtering to a thickness of 1000-3000Å (1Å equals $10^{-10}$m) on a substrate 40 of heat resistant glass such as AN glass or Pyrex glass which is resistant to temperatures as high as approximately 600°C. The conditions under which this process was carried out were: a 100% oxygen atmosphere; a temperature for the film formation of 150°C; an RF apparatus power output of 400-800W; and a total atmospheric pressure of 0.5Pa. The deposition rate in the case where quartz or single crystalline silicon was used for the sputtering target was 30-100Å/minute. A silicon film 42 was then formed on the silicon oxide film 41 by LPCVD (Low Pressure Chemical Vapour Deposition), sputtering or plasma CVD, and patterned by a known photolithographic technique to obtain a structure as shown in Fig. 3(A).

In the case where the silicon film 42 was formed by LPCVD, disilane ($Si_2H_6$) or trisilane ($Si_3H_6$) was supplied to a CVD device at a temperature 100-200°C lower than that for crystallization, ranging between 450°C and 550°C and typically 530°C. The atmospheric pressure in the reactive furnace was in the range of 30-300Pa and the deposition rate was in the range of 50-250Å/minute. In order to control the threshold voltage (Vth) for the NTFTs and PTFTs to be almost the same level, boron may be added at the time of film formation at an atomic concentration of from $1 \times 10^{14}$ to $1 \times 10^{17} cm^{-3}$ using diborane.

In the case where the silicon film 42 was manufactured by sputtering, the back pressure of the deposition chamber before sputtering was not more than $1 \times 10^{-5} Pa$, and the manufacture was carried out in an atmosphere where 20-80% of hydrogen was incorporated into argon (typically in an atmosphere comprising 20% argon and 80% hydrogen), using a target composed of single crystalline silicon, at a depositing temperature of 150°C, with a 13.56MHz RF sputtering apparatus having a power output of 400-800W and under an atmospheric pressure of 0.5Pa.

In the case where the silicon film 42 was formed by plasma CVD, the reaction temperature was, for example, 300°C, and monosilane ($SiH_4$) or disilane ($Si_2H_6$) was introduced into a plasma CVD device where it was subjected to the application of high-frequency power at 13.56MHz for promoting film formation.

The silicon film formed by these methods is typically subjected to crystallization in a subsequent process as described infra. The concentration of oxygen included in the coated film is preferably not more than $7 \times 10^{19} cm^{-3}$, and more preferably not more than $1 \times 10^{19} cm^{-3}$, in order to facilitate the crystallization process. According to the results of SIMS (Secondary Ion Mass Spectrometry) on the coated film obtained in accordance with this embodiment, the levels of impurities were $8 \times 10^{18} cm^{-3}$ for oxygen, $3 \times 10^{16} cm^{-3}$ for carbon, and $4 \times 10^{20} cm^{-3}$ for hydrogen, which formed a total of one atom% which compared with a silicon density defined as $4 \times 10^{22} cm^{-3}$.

After the amorphous silicon film was manufactured to a thickness ranging from 500 to 3000Å, e.g. 1500Å, a middle temperature heat treatment of the film was carried out at a temperature of 450-700°C (e.g. 600°C) for 12-70 hours in a non-oxidising nitrogen or hydrogen atmosphere. Since an amorphous silicon oxide film was formed on the substrate surface before the formation of the silicon film, a specific core does not exist during the heat treatment and the whole body is uniformly heated and annealed. As deposited, the silicon film has an amorphous structure with hydrogen simply incorporated therein. By employing annealing, the silicon film is transformed from its amorphous structure into another higher order state, a part of which shows a crystalline condition. In particular, a relatively higher order region of the coated film formed by the foregoing methods (LPCVD, sputtering, and plasma CVD) tends to be crystallized into a crystalline region. However, silicon atoms are pulled towards each other since bonds are formed between such regions by silicon atoms existing therebetween. In observations conducted into the crystallinity of the film Laser Raman Spectroscopy results show a peak shifted to a frequency lower than the single crystalline silicon peak of 522 $cm^{-1}$. The apparent grain size calculated based on a half band width is 50-500Å, which is at the level of microcrystals, but in practice the regions having a higher degree of crystallization are many in number and have a cluster structure, and a coating having a semi-amorphous structure in which crystalline clusters are anchored to each other through respective silicon atoms, was formed. Consequently, the film exhibits a state where it can be said that substantially no grain boundaries (referred to as GB) exist therein. Since carriers can move between clusters through the anchored points, the carrier mobility becomes higher than that of polycrystalline silicon in which GB obviously exists. Namely, Hall mobility in the range ($\mu h$)=10-200$cm^2$/Vsec and electron mobility in the range ($\mu e$)=15-300$cm^2$/Vsec can be obtained.

Polycrystalline silicon can be formed by crystallization of a film by means of high-temperature annealing at a temperature ranging from 900 to 1200°C, instead of the middle-temperature annealing described above. In this case, due to segregation of the impurities in the film caused by solid phase growth from the core, impurities such as oxygen, carbon, and nitrogen are increased in GB, that is, a barrier is formed at GB, whereby, though mobility in the crystal is large, the barrier at GB hinders carrier movement there. As a result, it is hard to achieve a mobility greater than 10$cm^2$/Vsec in practice. However, by decreasing the concentrations of impurities such as carbon (C), nitrogen (N) or oxygen (O) to one or more tenths of their concentrations in a semi-amorphous semiconductor, higher mobility of the order of 30-300$cm^2$/Vsec can be obtained.

As mentioned above, in the embodiment of Figs. 3 and 4 a silicon semiconductor layer 42 having a semi-amorphous, semi-crystalline or crystalline structure is formed. Next, a silicon oxide gate insulating film 43 of a thickness ranging from 500Å to 2000Å, e.g. 1000Å, is formed by the same method as was used for the deposition of the silicon oxide blocking layer 41. To the coated film, a small amount of fluorine may be added during the formation of the film. Further, on the upper surface thereof, a silicon film doped with phosphorus at a density of 1-5 x $10^{20}$cm$^{-3}$, or a multi-layered film comprising such a silicon film and a molybdenum (Mo), tungsten (W), MoSi$_2$ or WSi$_2$ film formed thereupon, was formed, which was then subjected to a patterning process using a photomask, so as to form a gate electrode 27. A deposition structure as shown in Fig. 3(B) was thus obtained and comprised: a channel length of 10μm, and P-doped Si of 0.2μm serving as a gate electrode, on which molybdenum of 0.3μm has been deposited.

Referring to Fig. 3(C), a photoresist pattern was formed using a photomask, and, for forming PTFTs, boron was added at a dose of 1 x $10^{15}$cm$^{-2}$ to source and drain regions 24 and 31 respectively by ion implantation. For forming NTFTs, phosphorus would be added at a dose of 1 x $10^{15}$cm$^{-2}$ by ion implantation or plasma doping so as to form source and drain regions 25 and 33 respectively. In this embodiment, since the PTFTs 22 and NTFTs 23 are parallel as shown in Fig. 4, one conductivity type TFTs are masked with photoresist or the like when carrying out ion implantation to the other conductivity type TFTs. The ion implantation was carried out in both cases 'through the gate insulating film 43. Alternatively, referring to Fig. 3(B), with the gate electrode 27 used as a mask, the silicon oxide layer formed on the silicon film can be selectively removed, after which, boron or phosphorus can be ion-implanted directly into the silicon film. Thermal annealing was carried out again at 600°C for 10-50 hours in order to activate the impurities. The source 25 and the drain 33 for each NTFT, as well as the source 24 and the drain 31 for each PTFT in Fig. 4 were obtained as N$^+$-type and P$^+$-type, respectively by virtue of the activation. Under the gate electrode 27, a channel region 44 is obtained as a crystalline semiconductor of higher mobility.

In this way, in addition to the employment of self-alignment techniques, the C/TFT 30 shown in Fig. 4 can be prepared without elevating the temperature to higher than 700°C during its manufacture. Therefore, it is not necessary to use an expensive substrate such as quartz. Furthermore, the process of the present invention as described above is suitable for manufacturing a liquid crystal display device having a large display area.

Referring to Figs. 3(A) and 3 (D), thermal annealing was performed twice, however, the annealing process related to Fig. 3(A) can be omitted and the two separate annealings replaced with one annealing related to Fig. 3(D) so as to shorten the manufacturing time.

Referring to Fig. 3(E), a silicon oxide interlayer insulating film 45 was formed by sputtering as above-mentioned, though the silicon oxide film can also be formed by LPCVD or by photo-CVD. The thickness of the interlayer insulating film 45 was, for example, 0.2-0.4μm. After the formation of the silicon oxide film 45, a window 46 for an electrode was formed using a photomask. Aluminium was then deposited over the entire surface of the device by sputtering and was patterned using a photomask to form an electrode 26 and a contact 48. Further, an ITO (Indium Tin Oxide) film was deposited by sputtering and patterned by etching, using a photomask to obtain picture element electrodes 32 as shown in Fig. 4(A). As shown in Fig. 4(A), the two TFTs 22 and 23 are complementary transistors. As shown in Fig. 4(A), output terminals of the TFTs 22 and 23 are connected to the picture element electrode 32 of the liquid crystal device. The ITO was deposited between room temperature and a temperature up to 150°C, and was annealed in an oxygen atmosphere or in air at a temperature between 200-400°C.

In this way, PTFT 22, NTFT 23, and the transparent conductive film electrode 32 were formed on the same glass substrate 40. The properties of the TFTs are briefly described in Table 1 below:

Table 1

| | Mobility $\mu$ ($cm^2$/Vs) | $V_{th}$ (threshold voltage) |
|---|---|---|
| PTFT | 20 | -3 |
| NTFT | 30 | +3 |
| | | |

By using semiconductors prepared in this way, a high mobility was achieved in the TFTs, which had been generally accepted as impossible. Complementary TFTs for a liquid crystal electro-optic device and the like as shown in Figs. 2, 3, and 4, i.e. MTG (modified transfer gate) C/TFTs, were thus formed for the first time.

Referring to Fig. 4, wirings in an X-axis direction (hereinafter also referred to as X-lines) such as $V_{DD}$ line 26, $V_{DD'}$ line 50, and $V_{DD''}$ line 51 were formed. In a Y-axis direction, wirings in the Y-axis direction (hereinafter also referred to as Y-lines) such as $V_{GG}$ line 29 and $V_{GG}$. line 52 were formed. Fig. 4(A) is a plan view, and an A-A' longitudinal section is shown in Fig. 4(B) and a B-B' longitudinal section in Fig. 4(C). NTFT 23 and PTFT 22 are provided near the intersection of the X-line $V_{DD}$ 26 and the Y-line $V_{GG}$ 29, so as to form the C/TFT 30. C/TFTs having the same structure are formed for each of the other picture elements so as to obtain the matrix structure shown in Fig. 4(A). In NTFT 23 and PTFT 22 that constitute C/TFT 30, source and drain regions are connected to the picture element electrode 32 made of a transparent conductive film and to one signal line 26 in the matrix structure, through the contact 48 and electrode 26. On the other hand, gate electrodes 27, 28 of NTFT 23, PTFT 22 are linked to a gate wiring of the other signal line 29.

A pixel of the display is thus defined by the transparent conductive film 32 and C/TFT 30 within the space bounded by two X-lines 26, 50 and two Y-lines 29, 52. By repeating this structure horizontally and vertically, large liquid crystal electro-optic devices providing large area displays, such as 640 x 480 pixels or 1280 x 960 pixels, can thus be manufactured.

Fig. 4 shows the structure of one of the substrates which sandwich the liquid crystal material in the liquid crystal electro-optic device. On this one of the substrates an orientation control film was formed and subjected to an orientation process, and then this substrate and the other one of the substrates carrying the other picture element electrodes were arranged parallel to each other at a certain spacing by a known method. A liquid crystal material was then injected between the spaced-apart substrate so as to complete the manufacture of the liquid crystal electro-optic device in accordance with this embodiment.

When a TN liquid crystal is to be used as the liquid crystal material, the spacing between the respective substrates is approximately 10µm, and the orientation films which are subjected to rubbing treatments have to be formed on transparent conductive films formed on both of the substrates. When a ferroelectric liquid crystal is to be used as the liquid crystal material, the operating voltage of the display is, for example ±20V, while the spacing of the cell is 1.5-3.5µm, e.g. 2.3µm, and the orientation control film is provided only on the counter electrodes and subjected to a rubbing process. When a dispersive liquid crystal or a polymeric liquid crystal is to be used no orientation control film is needed, the driving voltage is determined as ±10-±15V in order to increase switching speed, and the spacing between the pair of substrates between which the liquid crystal is sandwiched, is as low as 1-10µm. When a dispersive liquid crystal is used, no polarizing plate is necessary and the quantity of light transmitted by the liquid crystal device can be increased both in a reflective mode as well as in a transmissive mode. Further, since the liquid crystal does not have a threshold, by using the driving device (C/TFT) in accordance with the present invention, high contrast can be obtained because the driving device has a clear threshold voltage, while crosstalk or damaging interference with adjacent picture elements is eradicated.

Although the described embodiment employs a semiconductor of high mobility, it will be apparent to those possessed of appropriate skills that a semiconductor of another crystalline structure can be used instead. Furthermore, whereas a liquid crystal electro-optic device has been described, it will be clear that the modified transfer gate C/TFTs in accordance with the present invention can be used for other electro-optic devices in which a voltage is applied to a picture element electrode so as to cause some sort of displaying operation to be effected.

Salient features of the present invention are that two TFTs are provided for each picture element in a complementary structure, and the liquid crystal electric potential $V_{CL}$, that is the electric potential of the electrode 32, is fixed either at a first level corresponding to the case where the PTFT is ON and the NTFT is OFF, or a second level corresponding to the case where the PTFT is OFF and the NTFT is ON.

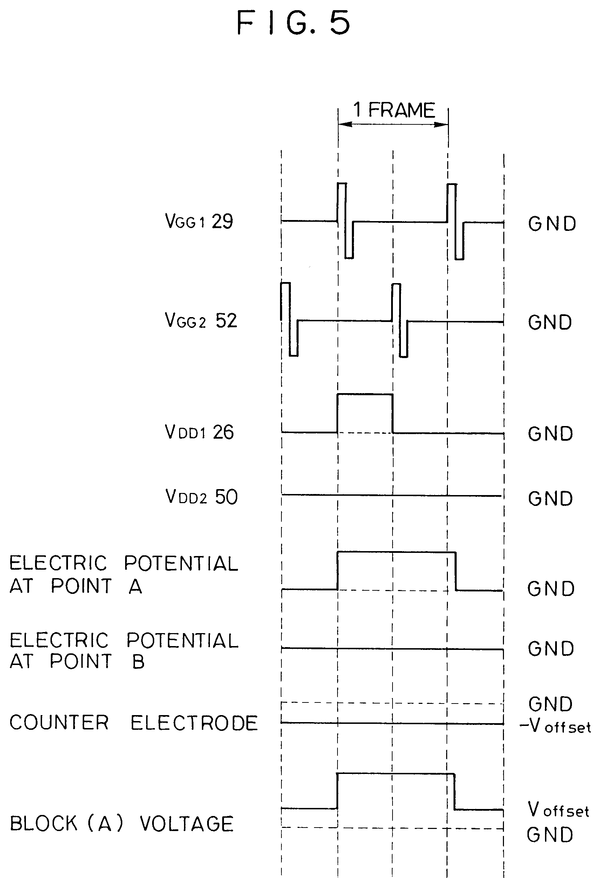

The principle of operation of this embodiment is explained below with reference to Figs. 2 and 5. Fig. 2 shows the equivalent circuit of a 2 x 2 matrix structure. By applying signal voltages to signal lines $V_{GG1}$ 29, $V_{GG2}$ 52, $V_{DD1}$ 26, and $V_{DD2}$ 50 shown in the figure, voltage is applied to the liquid crystal 1 in Fig. 2, so as to operate the liquid crystal display. Fig. 5 shows a waveform chart of the driving signal voltage applied to the signal lines $V_{GG1}$ 29, $V_{GG2}$ 52, and $V_{DD1}$ 26, $V_{DD2}$ 50, as well as to the counter electrode 55, for applying voltage to the liquid crystal existing at the point A. As shown in Fig. 5, one frame is divided into two in the case of a 2 x 2 matrix. The voltage actually applied to the liquid crystal 1 in this case is indicated as block (A) voltage. Though digital operation (ON/OFF operation) is carried out by the application of the voltage shown in Fig. 5, signal voltages applied to $V_{DD1}$ and $V_{DD2}$ should be modified to suit the desired degree of gradation. For example, in the case shown in Fig. 2, if the transmissivity of the liquid crystal at point A is required to be high, a higher signal voltage must be applied to $V_{DD1}$ in Fig. 5 so as to increase the transmissivity of the liquid crystal, whereas if the transmissivity of the liquid crystal is required to be small, a lower signal voltage will be applied thereto.

The signal voltage applied to $V_{GG1}$, $V_{GG2}$ must be larger than the threshold voltage $V_{th}$ of the C/TFTs, i.e. $V_{GG} \gg V_{th}$. Further, and as shown in Fig. 5, the application of a negative electric potential $V_{OFFSET}$ to the counter electrode is useful in a gradation display which is dependent upon the relationship between the light transmissivity of the liquid crystal and the voltage applied thereto because the application of the negative electric potential $V_{OFFSET}$ effectively makes the block (A) voltage larger. It is preferred that the absolute value of $V_{OFFSET}$ is not more than the threshold voltage of the liquid crystal.

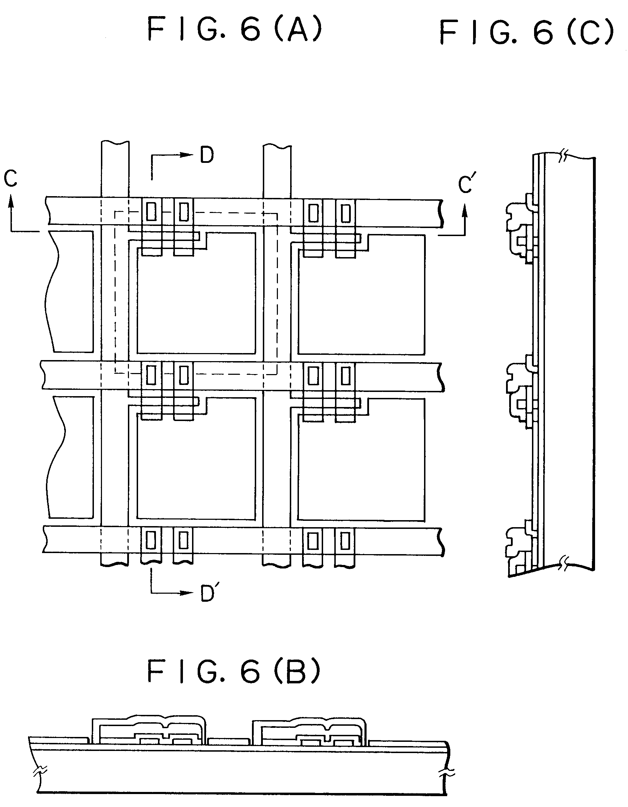

Referring now to Figs. 6(A) to 6(C), a liquid crystal electro-optic device in accordance with a second preferred embodiment will now be described. The picture element electrode 32 made of a transparent conductive film was formed last in the first embodiment, but in the second embodiment a transparent conductive film is formed on the blocking layer 41 first formed on the substrate, and the transparent conductive film is patterned so as to obtain the picture element electrodes 32. Therefore, there is no fear that disconnection might occur. Furthermore, since the p-channel transistors and n-channel transistors are formed on the substrate after formation of the picture element electrodes, therefore there is no risk that the transistors might be damaged by the patterning of the picture element electrodes. In other respects the manufacturing process and the structure of the device of Fig. 6 are the same as in the first embodiment, and thus will not be further described.

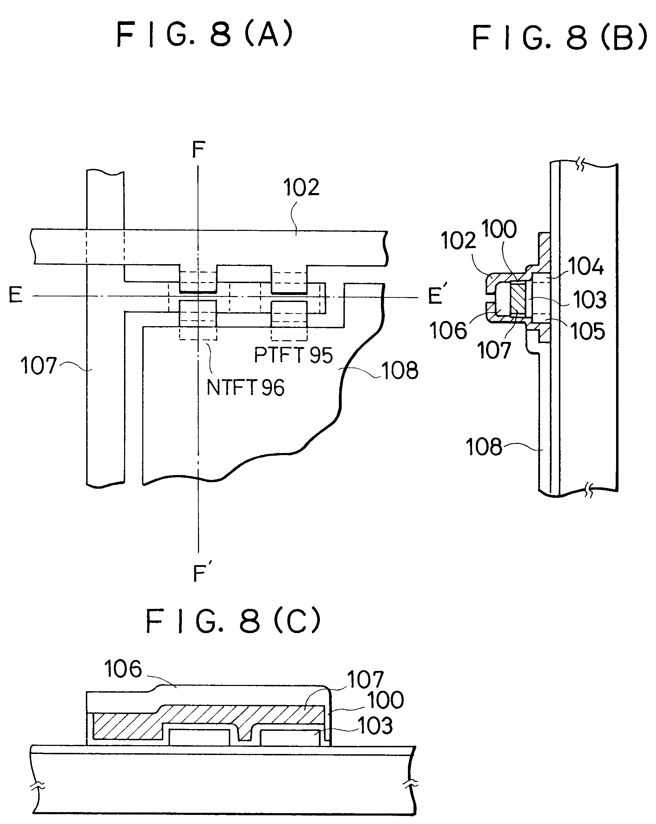

A third embodiment of the invention is shown in Fig. 8 and comprises a liquid crystal electro-optic device provided with modified transfer gate TFTs in a complementary structure obtained by using an anode plate technique (anodic oxidation technique). The manufacture of TFTs in accordance with this embodiment is basically the same as that in accordance with the first embodiment, and the process proceeds in almost the same manner as that depicted in Fig. 3. However, a metallic material is used for the gate electrode of the TFTs and an oxide insulating film is formed by oxidizing the metallic gate electrode material by an anodic oxidation technique. As shown in Fig. 8, the gates of PTFT 95 and of NTFT 96 are connected to a common gate line 107, and one source and one drain region of the two TFTs are connected together, to signal line 102, while the other source and drain regions of the two TFTs are connected to a picture element electrode 108 in common.

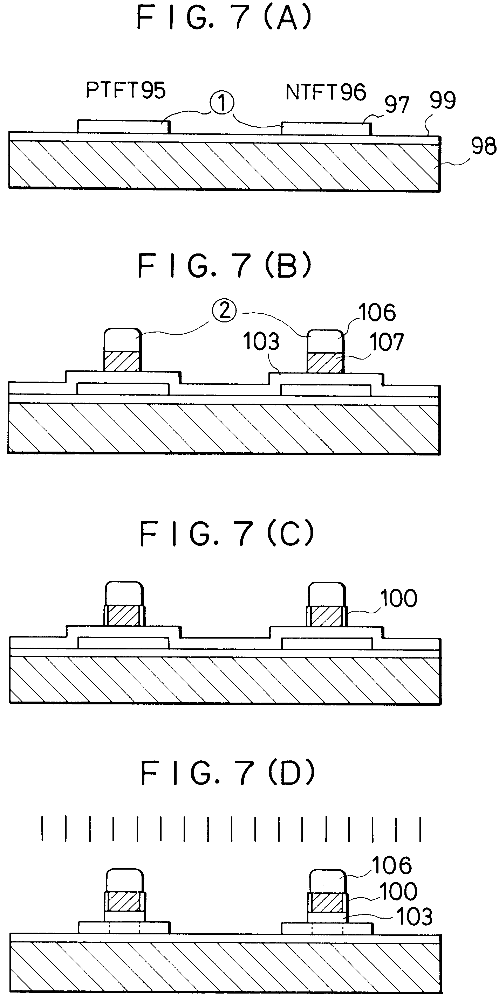

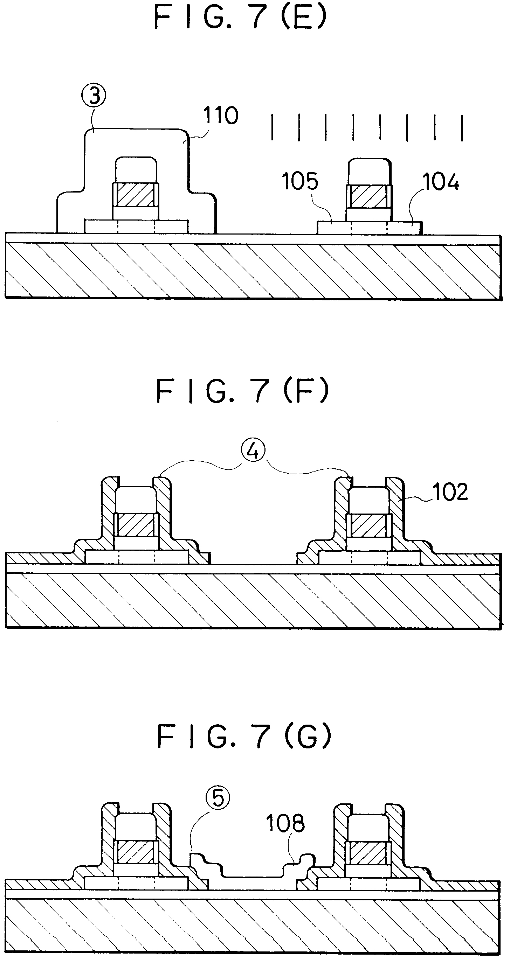

Referring to Figs. 7(A) through 7(G) which illustrate the manufacture of the device of Fig. 8, a silicon oxide film was formed on a glass substrate 98 to a thickness of 1000-3000Å by magnetron RF (high frequency) sputtering and served as a blocking layer 99. The process conditions were: an atmosphere of 100% oxygen; a deposition temperature of 15°C; an RF apparatus power output of 400-800W; and an atmospheric pressure of 0.5Pa. The depositing rate in the case where quartz or single crystalline silicon was used as a sputtering target was 30-100Å/minute. A silicon film 97 was then formed on the blocking layer 99 by LPCVD (Low Pressure Chemical Vapour Deposition), sputtering or plasma CVD. Referring to Fig. 7(A), photo-etching was carried out on the silicon film 97 with a first photomask ①, so as to form a region for formation of a PTFT on the left-hand side of the drawing, as well as a region for formation of an NTFT on the right-hand side. A silicon oxide film was formed to a thickness of 500-2000Å, e.g. 700Å, and served as a gate insulating film 103. The manufacturing conditions were the same as those for the silicon oxide film 99 which was formed as a blocking layer.

An alloy film of aluminium and silicon was then formed on the gate insulating film 103 to a thickness of 3000Å-1.5µm, e.g. 1µm, by sputtering and served after patterning the gate electrode 107.

As the gate electrode material, besides aluminum silicide, one or more of molybdenum(Mo), tungsten(W), titanium(Ti), tantalum(Ta) or chromium(Cr) can be used, and also alloys in which silicon is mixed with one or more of these elements, or alloys of these elements can be used. Also, a multi-layered film comprising a silicon layer and a metallic layer can be used for the gate electrode.

A silicon oxide film was then formed on the gate electrode material to a thickness of 3000Å-1µm, e.g. 6000Å, by sputtering and served as an insulating film, and subsequently the insulating film and the gate electrode material were patterned by use of a second photomask ②, so as to form the gate electrode 107 and the insulating film 106, as shown in Fig. 7(B).

The structure formed by the foregoing steps was then immersed in an AGW electrolyte comprising propylene glycol and a 3% tartaric acid solution in a ratio of 9:1, and the gate electrode formed of aluminium silicide was connected to the anode of a power source, and, with the use of platinum as a counter cathode, dc electric power was applied. The gate electrode being connected to each gate wiring, a connection terminal was provided in such a way that all of the gate wirings were sandwiched and were connected in the vicinity of the end of the substrate, and anodic oxidation was performed so as to form the anodic oxidation film 100 in the vicinity of the side surface of the gate electrode as is shown in Fig. 7(C).

As the solution used for the anodic oxidation, a mixed acid and the like for which ethylene glycol or propylene glycol and so on are added to a strong acid solution such as sulfuric acid, nitric acid, and phosphoric acid, or to tartaric acid, or citric acid, is typically used. According to requirements, a salt or alkali solution can be mixed therewith in order to adjust the pH of the required solution.

The anodic oxidation was carried out for 30 minutes at a current density of 2.5mA/cm$^2$ in a constant-current mode, and subsequently for 5 minutes in a constant-voltage mode, so as to form aluminium oxide of 2500Å thickness in the vicinity of the side surface of the gate electrode. Examination of the insulating characteristics of the aluminium oxide using a sample manufactured under the same conditions as the above described oxidation process, showed its characteristics to be $10^9$ $\Omega$m of resistivity and $2 \times 10^5$V/cm of dielectric strength. Through observation of the surface of the sample by scanning electron microscope, an unevenness on the surface was observed when magnified by approximately 8000 times, however no fine holes were observed which is evidence of a good insulating coating.

After the insulating film 103 was removed by etching as shown in Fig. 7(D), boron was added to the entire surface of the substrate by ion implantation at a dose of 1-5 x $10^{15}$cm$^{-2}$ as an impurity for the PTFT. The doping concentration was approximately $10^{19}$cm$^{-3}$, and source and drain regions for the PTFT were thus formed. In this embodiment, ion doping was carried out after the removal of the surface insulating film, however doping through the insulating film 103 on the semiconductor film can be carried out under suitable conditions.

A photoresist 110 was then formed using a third photomask ③ to cover the PTFT region as shown in Fig. 7(E), and subsequently phosphorus was added to the source and drain regions of the NTFT by ion implantation at a dose of 1-5 x $10^{15}$cm$^{-2}$. The doping concentration was about $10^{20}$cm$^{-3}$. The ion doping process was carried out in an ion implanting direction oblique to the substrate. Impurities reached a region under the anodic oxidation film and the ends of the source and drain regions 104 and 105 were almost aligned with the ends of the gate electrode. Sufficient insulating effect was ensured by the anodic oxidation film 100, to the electrode wiring formed in the following process, and this fact obviates the need for formation of another insulating film.

Laser light was then irradiated on to the source and drain regions for activation purposes, and since this was carried out substantially instantaneously, thus no need arose for caring about diffusion of the metal material used for the gate electrode and a TFT of high reliability was thus manufactured.

On the entire surface of all of these layers, aluminium was deposited by sputtering, and after an electrode lead 102 was obtained by patterning the aluminium by a fourth mask ④, the semiconductor film protruded from the electrode 102, the insulating film 106 on the gate electrode 107, as well as from the anodic oxidation film 100 in the vicinity of the side surface of the gate electrode 107, was removed by etching, and perfect device separation was carried out, so as to complete the TFT. In this manufacturing process, complementary TFTs were manufactured with four masks.

As shown in Fig. 7(G), the two TFTs are complementary transistors, and an ITO (Indium Tin Oxide) film was deposited by sputtering to connect the output ends of the two TFTs to an electrode of one picture element of the liquid crystal device. It was etched with a fifth photomask ⑤, so as to form the picture element electrode 108.

In this way, a modified transfer gate TFT having the arrangement and structure shown in Figs. 8(A), (B), and (C) was completed. Fig. 8(B) is a cross-sectional view corresponding to the F-F′ cross section of Fig. 8(A), while Fig. 8(C) is a cross-sectional view corresponding to the E-E′ cross section of Fig. 8(A). As is obvious from Figs. 8(B) and (C), the interlayer insulating film 106 never fails to exist on the gate electrode 107, and the lead of the gate wiring 107 and the lead of the source or drain wiring 102 are sufficiently insulated from each other at their intersection to avoid the generation of wiring capacity at the intersection. In this way, in this embodiment, an active device substrate whose capacitance in the vicinity of its wiring is much reduced, for which the possibility of shortcircuit in the vicinity of the gate insulating film is also reduced, and which has complementary TFTs, was completed with the number of masks needed being less than that in accordance with the first embodiment and without using a high-degree process technique of anisotropic etching.

The substrate formed by the foregoing steps is then operatively associated with a second substrate (a counter substrate) on which a counter electrode and an orientation control film is formed, and STN liquid crystal is injected between the substrates by a known method, whereby an active matrix STN liquid crystal electro-optic device is completed.

Exemplified applications to liquid crystal electro-optic devices were described in all of the above-mentioned cases, however, it is clear that, far from being limited to these examples, applications of the present invention to other devices, such as for example a three-dimensional integrated circuit device or the like, are also possible.

By following the teachings of this embodiment, the manufacture of TFT devices using a number of masks far less than is conventional becomes possible. By manufacturing a semiconductor product with the application of a device of this structure, the manufacturing process was facilitated and production yield was improved, as the number of masks becomes smaller, and a semiconductor application device of low manufacturing cost was thus offered.

This embodiment is characterized by using a metallic material for the gate electrode so that an oxide film can be provided on the surface thereof by means of anodic oxidation of the metallic material, and by providing a three-dimensional wiring having a grade separation thereupon. In addition, since the gate electrode and the oxide film provided on the side surface of the gate electrode do not hinder contact of leads to source and drain regions, the TFTs become smaller and/or the channel region becomes nearer to the leads. Therefore, a reduction in the frequency response of the device and an increase in its ON resistance were prevented.

When aluminium was used for the gate electrode material as described in this embodiment, $H_2$ was changed to H in the gate oxide film at an annealing stage in the device forming process due to the catalytic effect of aluminium, and accordingly the amount of hydrogen in the gate oxide film was reduced and the interface state density ($Q_{SS}$) was also reduced, compared to the situation when a silicon gate was used instead, whereby the device characteristic was improved.

Since the source and drain regions of the TFTs, as well as the contacts of the electrodes connected to the source and drain regions, were formed in a self-aligning manner, the area required for the TFTs is reduced and the degree of integration can be correspondingly improved. When such TFTs were used as active devices in a liquid crystal electro-optic device, the aperture ratio of the liquid crystal panel was improved. TFTs having a structure as characterized in the foregoing can be manufactured by the use of as few as two or more masks.

The foregoing description of preferred embodiments has been presented for purposes of illustration and description. It is not intended to be exhaustive or to limit the invention to the precise form described, it is to be well umderstood that many modifications and variations are possible without departure from the scope of the invention.

## Claims

1. An electronic device comprising a p-channel transistor and n-channel transistor pair provided in said electronic device and connected to each other in parallel, each of said p-channel and said n-channel transistors comprising a gate electrode and two input/output terminals, the gate electrode of said p-channel transistor being connected to the gate electrode of said n-channel transistor, one of the input/output terminals of said p-channel transistor and one of the input/output terminals of said n-channel transistor being connected to each other, and the other of the input/output terminals of said p-channel transistor and the other of the input/output terminals of said n-channel transistor also being connected to each other.

2. A device as claimed in claim 1 configured as an electro-optic device and further comprising a pair of substrates and a liquid crystal material provided between said substrates, and wherein said p-channel transistor and said n-channel transistor are provided on one of said substrates.

3. A device as claimed in claim 2 further comprising an electrode area provided on said one of said substrates and connected to said p-channel transistor and said n-channel transistor.

4. An electro-optic device comprising:
   a substrate;
   a p-channel transistor and n-channel transistor pair provided on said substrate and connected to each other in parallel, each of said p-channel and n-channel transistors comprising a gate electrode and two input/output terminals;
   a first signal line and second signal line provided on said substrate; and
   an electrode area provided on said substrate,
   one of the input/output terminals of said p-channel transistor and one of the input/output terminals of said n-channel transistor being connected to said electrode area, the other of the input/output terminals of said p-channel transistor and the other of the input/output terminals of said n-channel transistor being connected to one of said first and second signal lines, and the gate electrode of said p-channel transistor and the gate electrode of said n-channel transistor being connected to the other of said first and second signal lines.

5. A device as claimed in claim 4 further comprising:
   a further substrate spaced from the first-mentioned substrate; and
   a liquid crystal material provided in the gap between the two substrates.

6. An electro-optic device comprising:
   a pair of closely spaced substrates;
   a liquid crystal material provided in the gap between said substrates;
   electrode areas provided on one of said substrates in a matrix form at;
   signal lines provided on said one of said substrates; and
   pairs of complementary transistors associated with respective ones of said electrode areas provided on said one of said substrates, each one of said pairs comprising a p-channel transistor and an n-channel transistor connected to each other in parallel;
   each of said transistors comprising a gate electrode and two input/output terminals, and one of the input/output terminals of said p-channel transistor and one of the input/output terminals of said n-channel transistor being connected to the respective associated electrode area, the other of the input/output terminals of- said p-channel transistor and the other of the input/output terminals of said n-channel transistor being connected to one of said signal lines, and the gate electrode of said p-channel transistor and the gate electrode of said n-channel transistor being connected to another of said signal lines.

7. A device as claimed in claim 6 wherein said electrode areas comprise indium tin oxide.

8. A device as claimed claim 6 or 7 wherein each of said transistors comprises a channel region located between source and drain regions thereof under a gate electrode thereof and comprising a semi-amorphous semiconductor or a semi-crystalline semiconductor.

9. A method of manufacturing a device as claimed in any of the preceding claims, said method comprising:
   forming a semiconductor layer on a substrate;
   forming a gate insulating layer over said semiconductor layer;
   forming a gate electrode layer over said gate insulating layer;
   doping selected regions of the semiconductor layer to define source and drain regions;
   forming an insulating layer over the thus partly formed device; and accessing the source and drain regions through said insulating layer and providing electrical connections thereto.

10. A method as claimed in claim 9 for manufacturing an electro-optic device and including the formation of a picture element electrode on said substrate in contact with one of said electrical connections.

11. A method as claimed in claim 9 or 10 wherein the picture element electrode is formed on the substrate prior to the formation of the semiconductor and other layers.

12. A method as claimed in any of claims 9 to 11 wherein the gate electrode layer comprises a metallic material and the gate insulating layer is formed by an electrolytic oxidation technique.

# F I G. 1

# F I G. 2

# F I G. 3 (A)

42 41 40

# F I G. 3 (B)

27 43

# F I G. 3 (C)

31 24

# F I G. 3 (D)

# F I G. 3 (E)

45    46    45    46    45

# F I G. 3 (F)

32    45    48    45    27    26

45

31    44    24

# F I G. 4 (A)

# F I G. 4 (C)

# F I G. 4 (B)

# F I G. 5

1 FRAME

$V_{GG1}$ 29 — GND

$V_{GG2}$ 52 — GND

$V_{DD1}$ 26 — GND

$V_{DD2}$ 50 — GND

ELECTRIC POTENTIAL
AT POINT A — GND

ELECTRIC POTENTIAL
AT POINT B — GND

COUNTER ELECTRODE — GND / $-V_{offset}$

BLOCK (A) VOLTAGE — $V_{offset}$ / GND

# F I G. 6 (A)    F I G. 6 (C)

# F I G. 6 (B)

# F I G. 7 (A)

PTFT95　　　①　　　NTFT96　97　　99

98

# F I G. 7 (B)

②　　106
103　　107

# F I G. 7 (C)

100

# F I G. 7 (D)

| | | | | | | | | | | | | | | | | |

106
100
103

# F I G. 7 (E)

# F I G. 7 (F)

# F I G. 7 (G)

# FIG. 8 (A)

# FIG. 8 (B)

# FIG. 8 (C)

European Patent Office

**EUROPEAN SEARCH REPORT**

Application Number

EP 91 31 1477

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | PATENT ABSTRACTS OF JAPAN vol. 014, no. 219 9 May 1990 & JP-A-20 050 132 ( HITACHI LTD. ) 20 February 1990 * abstract * | 1-6 | H01L27/12 H01L21/84 G09G3/36 |
| Y | EP-A-0 375 233 (SEIKO EPSON CORPORATION) 27 June 1990 * column 2, line 28 - column 2, line 42; figure 1 * | 1-6 | |
| Y | JAPANESE JOURNAL OF APPLIED PHYSICS, SUPPLEMENTS. vol. 22, no. 22-1, 1983, TOKYO JA pages 497 - 500; M. MATSUI ET AL.: 'A 10x10 polycrystalline-silicon thin-film transistor matrix for liquid.crystal display' | 1-6 | |
| X | * page 497, right column, paragraph 3 - page 498, right column, paragraph 1; figures 1-2 * | 9-10 | |
| X | US-A-4 917 467 (INDUSTRIAL TECHNOLOGY RESEARCH INSTITUTE) 17 April 1990 * column 4, line 32 - column 4, line 68; figure 8 * | 9-10 | TECHNICAL FIELDS SEARCHED (Int. Cl.5 ) H01L G02F G09G |
| A | US-A-4 332 075 (MATSUSHITA ELECTRIC INDUSTRIAL CO.) 1 June 1982 * column 2, line 33 - column 2, line 62 * * column 4, line 30 - column 5, line 53; figures 5-7 * | 7,11 | |
| A | DE-A-3 604 368 (SHARP K.K.) 14 August 1986 * page 11, line 25 - page 12, line 13; figures 8A-8B * | 12 | |

The present search report has been drawn up for all claims

| Place of search | Date of completion of the search | Examiner |
|---|---|---|
| THE HAGUE | 19 MARCH 1992 | FRANSEN |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)